# EUROPÄISCHE PATENTSCHRIFT

(11) **EP 2 029 474 B1**
(45) Veröffentlichungstag und Bekanntmachung des Hinweises auf die Patenterteilung: **19.07.2017**
(21) Anmeldenummer: 07727654.1
(22) Anmeldetag: 02.04.2007
(51) Int. Cl.: B81C 1/00, H04R 19/00, H04R 19/04, H04R 31/00

(54) **MIKROMECHANISCHES MEMRANBAUELEMENT UND VERFAHREN ZU DESSEN HERSTELLUNG**
MICROMECHANIC COMPONENT HAVING MEMBRANE AND METHOD FOR THE PRODUCTION THEREOF
COMPOSANT MICROMÉCANIQUE À MEMBRANE ET SON PROCÉDÉ DE FABRICATION

(30) Priorität: 26.05.2006 DE 102006024668
(43) Veröffentlichungstag der Anmeldung: 04.03.2009
(73) Patentinhaber: Robert Bosch GmbH, 70442 Stuttgart (DE)
(72) Erfinder: FEYH, Ando, 71732 Tamm (DE); LAMMER, Marco, 70199 Stuttgart (DE)
(86) Internationale Anmeldenummer: PCT/EP2007/053182
(87) Internationale Veröffentlichungsnummer: WO 2007/137893

(56) Entgegenhaltungen:
- EP-A- 1 215 476
- EP-A2- 0 561 566
- US-B1- 6 243 474
- BERGQVIST J ET AL: "A NEW CONDENSER MICROPHONE IN SILICON" SENSORS AND ACTUATORS A, ELSEVIER SEQUOIA S.A., LAUSANNE, CH, Bd. A21 - A23, 1. Februar 1990 (1990-02-01), Seiten 123-125, XP000573229 ISSN: 0924-4247

## Beschreibung

### Stand der Technik

Die Erfindung betrifft ein mikromechanisches Bauelement mit einem Schichtaufbau, der mindestens eine Membran auf der Oberseite und mindestens ein Gegenelement umfasst, wobei zwischen der Membran und dem Gegenelement ein Hohlraum ausgebildet ist und das Gegenelement mindestens eine Durchgangsöffnung zu einem Rückvolumen aufweist. Des Weiteren betrifft die Erfindung ein Verfahren zur Herstellung eines solchen Bauelements.

Derartige Bauelemente werden in der Praxis häufig als Mikrofonelement beispielsweise im Rahmen von Hörgeräten oder Mobilkommunikationssystemen eingesetzt. Die Membran dient hier als Schallaufnehmer. Bei kapazitiv arbeitenden Mikrofonen ist das Gegenelement als Gegenelektrode für die ebenfalls als Elektrode fungierende Membran ausgelegt. Die Durchgangsöffnungen im Gegenelement ermöglichen einen Druckausgleich zum Rückvolumen.

In der deutschen Patentanmeldung 10 2005 042664.6 wird ein Bauelement der eingangs genannten Art beschrieben. Der Schichtaufbau dieses Bauelements umfasst eine Membran, die durch oberflächenmikromechanische Prozessierung erzeugt worden ist. Sie ist über den restlichen Chipbereich erhaben und überspannt einen Hohlraum, dessen Boden durch ein Gegenelement gebildet wird. Durch Rückseitenprozessierung des Schichtaufbaus wurde die Rückseite des Gegenelements freigelegt. Zudem weist das Gegenelement Durchgangsöffnungen auf, so dass der Druckausgleich hier über die Rückseite des Bauelements erfolgt. Die US 6 243 474 B1 offenbart gleichfalls ein Bauelement der eingangs genannten Art wobei der Druckausgleich in diesem Fall durch einen zum Schichtaufbau parallelen Kanal zur Bauteilseite hin ermöglicht wird. Viele Anwendungen für Bauelemente der hier in Rede stehenden Art erfordern einen hohen Grad an Miniaturisierung. Dies kann einerseits durch Verkleinerung der mikromechanischen Strukturelemente erreicht werden, wobei die elektroakustische Leistungsfähigkeit beibehalten oder sogar noch verbessert werden sollte, und andererseits durch Integration der Auswerteelektronik auf demselben Chip. Beide Maßnahmen lassen sich aber nur bedingt mit einer Rückseitenprozessierung des Schichtaufbaus, wie im Stand der Technik beschrieben, vereinbaren.

### Offenbarung der Erfindung

Mit der vorliegenden Erfindung wird eine kostengünstige Technologie bereitgestellt, die die mikromechanischen Sensorfunktionen und die Auswerteelektronik einfach auf einem Chip zu integrieren vermag und auch für eine Massenproduktion geeignet ist.

Dafür sieht das erfindungsgemäße Bauelementkonzept vor, dass das Rückvolumen des Bauelements durch einen abgeschlossenen weiteren Hohlraum unterhalb des Gegenelements gebildet wird und dass der weitere Hohlraum unterhalb des Gegenelements über mindestens eine Druckausgleichsöffnung an die Oberseite des Schichtaufbaus angebunden ist.

Die Struktur des erfindungsgemäßen Bauelements ist so konzipiert, dass sie durch rein oberflächenmikromechanische Prozessierung (OMM) erzeugt werden kann. Eine Prozessierung der Rückseite des Schichtaufbaus in Bulk-Mikromechanik (BMM) ist nicht erforderlich, wodurch zusätzliche Prozessschritte und damit Herstellungskosten eingespart werden. Ein weiterer Vorteil der rein oberflächenmikromechanischen Prozessierung liegt in der Vielzahl von realisierbaren Designs und Bauformen in minimaler Strukturgröße. So können beispielsweise SMD-taugliche Chips von geringer Größe durch OMM hergestellt werden, was mit BMM nicht möglich ist. Außerdem lässt sich die Technologie der OMM mit den Herstellungstechniken der Mikroelektronik verbinden, so dass kostengünstige Batch-Prozesse für die Serienproduktion des erfindungsgemäßen Bauelements eingesetzt werden können. Da die Prozesse der OMM und CMOS-Prozesse in der Regel kompatibel sind, lassen sich Sensorstruktur und Auswerteelektronik zudem einfach auf einem Chip integrieren.

Bei einer vorteilhaften Variante des erfindungsgemäßen Bauelements weist der Hohlraum unterhalb des Gegenelements mindestens eine Einschnürung auf. Alternativ kann dieser Hohlraum auch durch mehrere miteinander kommunizierende Kavernen gebildet sein. Die Wandung des Hohlraums bildet in diesem Fall eine Abstützung für das Gegenelement und erhöht dessen mechanische Stabilität. Damit vergrößert sich die Prozessfreiheit bei der Herstellung des erfindungsgemäßen Bauelements, beispielsweise für eine Planarisierung des Gegenelements mit Hilfe von Plasma oder CMP.

Eine vorteilhafte Weiterbildung des erfindungsgemäßen Bauelements sieht eine Verkappung der Druckausgleichsöffnungen auf der Oberseite des Schichtaufbaus vor, um den Druckanschluss des Hohlraums unterhalb des Gegenelements seitlich umzulenken. Auf diese Weise kann einfach vermieden werden, dass der auf die Membran einfallende Druck auch über die Druckausgleichsöffnungen in den Hohlraum unterhalb des Gegenelements gelangt. So wird gewährleistet, dass dieser Hohlraum ein Ausgleichsvolumen für den Hohlraum zwischen der Membran und dem Gegenelement bildet. Eine derartige Verkappung der Druckausgleichsöffnungen kann beispielsweise in Form eines aufgebondeten Kappenwafers realisiert werden.

Wie bereits erwähnt, lässt sich die Struktur des erfindungsgemäßen Bauelements durch rein oberflächenmikromechanische Prozessierung erzeugen. Das erfindungsgemäße Verfahren zur Herstellung eines solchen Bauelements geht dazu von einem Substrat aus, auf dem mindestens eine erste Schicht erzeugt wird. In dieser ersten Schicht werden Öffnungen erzeugt, die sich zumindest bis zum Substrat erstrecken, wobei mindestens eine Öffnung als Durchgangsöffnung im Gegenelement im Bereich der zu erzeugenden Membran angeordnet wird und mindestens eine Öffnung als Druckausgleichsöffnung in einem Bereich neben der zu erzeugenden Membran angeordnet wird. In einem ersten Ätzschritt, der von der Oberseite des Schichtaufbaus ausgehend, über die Öffnungen in der ersten Schicht erfolgt, wird ein Hohlraum im Substrat unter der ersten Schicht erzeugt. Dann wird mindestens eine Opferschicht über der strukturierten ersten Schicht erzeugt, wobei die Öffnungen in der ersten Schicht verschlossen werden. In dieser Opferschicht wird ein Rahmenbereich für die Membran erzeugt und über der Opferschicht wird mindestens eine Schicht aus Membranmaterial abgeschieden und strukturiert. Danach wird die Membran freigelegt, indem das Opferschichtmaterial in einem zweiten Ätzschritt entfernt wird, der von der Oberseite des Schichtaufbaus ausgehend, über die Druckausgleichsöffnung in der ersten Schicht, den Hohlraum unter der ersten Schicht und die Durchgangsöffnung im Gegenelement erfolgt. Grundsätzlich gibt es verschiedene Möglichkeiten für die Realisierung, Ausgestaltung und Weiterbildung des erfindungsgemäßen Verfahrens. Dazu wird einerseits auf die dem unabhängigen Verfahrensanspruch nachgeordneten Patentansprüche und andererseits auf die nachfolgende Beschreibung von Ausführungsbeispielen der Erfindung anhand der Zeichnungen verwiesen.

### Zeichnungen

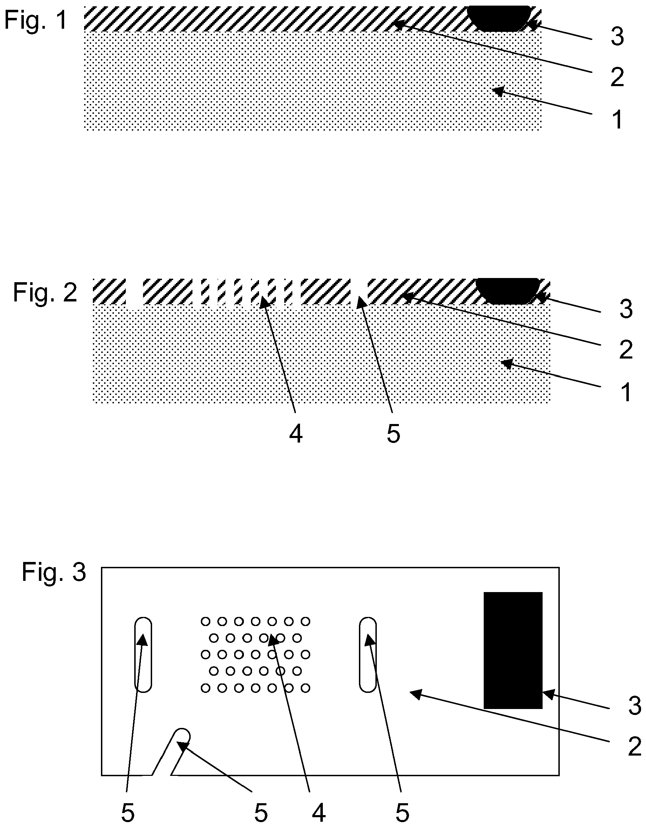

Die Figuren 1 bis 9 illustrieren die Abfolge der Verfahrensschritte zur Herstellung eines erfindungsgemäßen Bauelements. Bei den Figuren 1, 2 und 4 bis 9 handelt es sich um Schnittdarstellungen des Schichtaufbaus, während Fig. 3 eine Draufsicht auf die Oberseite des in Fig. 2 dargestellten Schichtaufbaus zeigt.

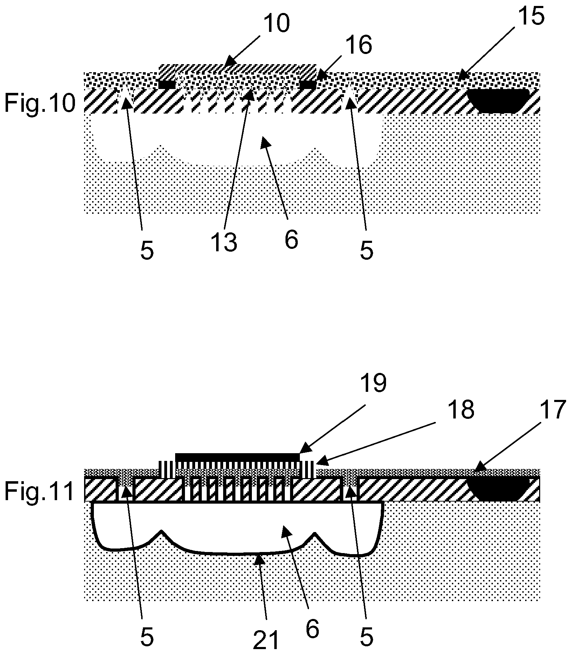

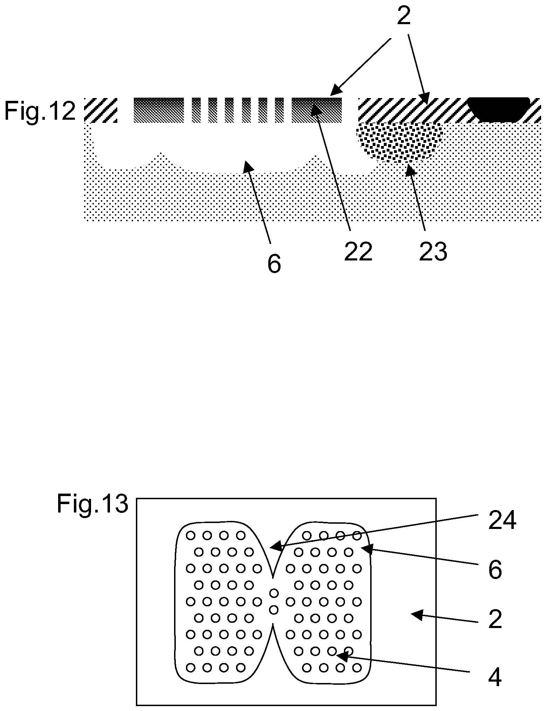

Die Figuren 10 bis 13 illustrieren vorteilhafte Varianten des Herstellungsverfahrens und beziehen sich deshalb jeweils nur auf einen Aspekt des Herstellungsverfahrens. Bei den Figuren 10 bis 12 handelt es sich um Schnittdarstellungen des Schichtaufbaus. Fig. 13 zeigt eine Draufsicht auf die Oberseite des Schichtaufbaus.

### Beschreibung der Ausführungsbeispiele

Wie voranstehend erläutert, wird die Struktur des erfindungsgemäßen Bauelements in einem Schichtaufbau durch oberflächenmikromechanische Prozessierung eines Substrats realisiert. Als Ausgangsmaterial im hier beschriebenen Ausführungsbeispiel dient ein p-dotiertes Siliziumsubstrat 1, dessen Dotierung und Orientierung beliebig sein können.

Vorzugsweise wird (100) orientiertes Material mit einem spezifischen Widerstand um 2,75 Ohm/cm verwendet, um auf Standard-CMOS-Prozesse zurückgreifen zu können. **Fig. 1** zeigt das Substrat 1 nach dem Aufbringen einer ersten Schicht 2, in der im Folgenden das Gegenelement der Bauelementstruktur ausgebildet wird. Bei der Schicht 2 handelt es sich hier um eine n-dotierte Epitaxieschicht mit einer Dicke von vorzugsweise zwischen 2 und 10 µm. Eine solche Schicht kann aber auch durch POC13-Belegung oder Implantation erzeugt werden. Als Auswerteschaltung für das Bauelement wurde ein ASIC 3 in die Schicht 2 integriert. Dieser kann bei Bedarf durch eine hier nicht dargestellte Maskierschicht gegen die nachfolgend beschriebene oberflächenmikromechanische Prozessierung geschützt werden.

In einem nächsten Verfahrensschritt, der durch die **Figuren 2 und 3** veranschaulicht wird, werden Öffnungen 4 und 5 in der ersten Schicht 2 erzeugt. Diese Öffnungen 4 und 5 werden hier in einem Trenchprozess geätzt und erstrecken sich bis in das Substrat 1. Die Öffnungen 4 sind als Durchgangsöffnungen im Gegenelement im Bereich unter der noch zu erzeugenden Membran konzipiert, während die Öffnungen 5 als Druckausgleichsöffnungen in einem Bereich neben der zu erzeugenden Membran angeordnet sind. Fig. 3 zeigt eine mögliche Anordnung und Geometrie der Öffnungen 4 und 5 in Aufsicht. So werden im Membranbereich bevorzugt kleinere Öffnungen 4 generiert, beispielsweise mit einem Durchmesser von ca. 0,5 bis 3 µm. Die Öffnungen 4 sind hier hexagonal angeordnet. Genauso können aber auch eine andere Anzahl und Anordnung von Öffnungen 4 gewählt werden. Deutlich größer sind die Öffnungen 5 ausgebildet mit einer Länge von bis hin zu mehreren 10 µm. Auch die Öffnungen 5 seitlich vom Membranbereich können beliebig angeordnet werden. Typisch sind Abstände zwischen einigen 10 µm bis zu 300 µm zum Membranbereich. Wie Fig. 3 veranschaulicht, können die Öffnungen 5 auch im Randbereich des Schichtaufbaus angeordnet werden, so dass der Druckausgleich beim Betrieb des Bauelements seitlich erfolgen kann.

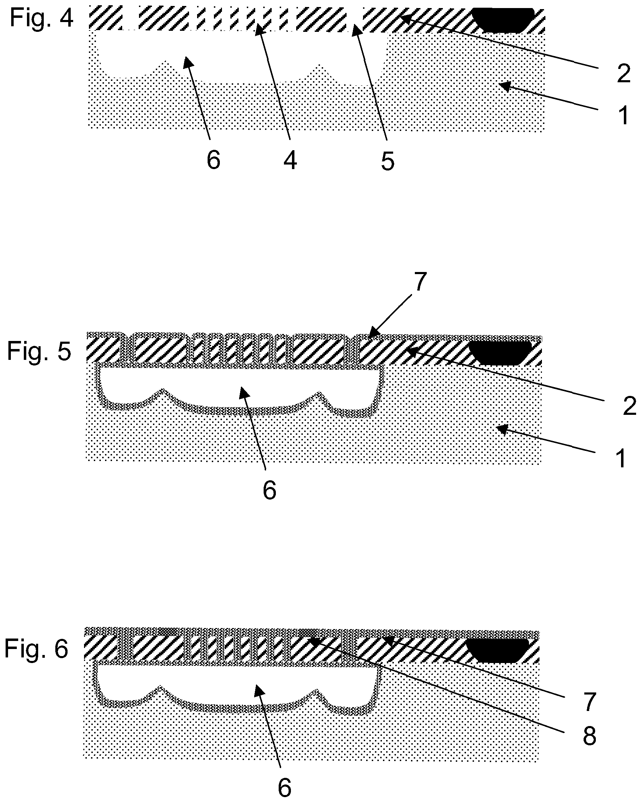

Die Öffnungen 4 und 5 dienen im anschließenden ersten Ätzschritt, der von der Oberseite des Schichtaufbaus ausgeht, auch als Ätzöffnungen, über die ein Hohlraum 6 im Substrat 1 unter der ersten Schicht 2 erzeugt wird. Im hier beschriebenen Ausführungsbeispiel umfasst der erste Ätzschritt einen Elektropoliturschritt in Flusssäure (HF). Dabei wird lediglich das p-dotierte Siliziumsubstrat 1 angegriffen. Aufgrund der hohen Dotierselektivität der elektrochemischen Auflösung von Silizium wird die n-dotierte erste Schicht 2 dagegen nicht angegriffen. Die Tiefe des Hohlraums 6 kann ohne Weiteres bis zu 300 µm betragen. Je nach Einstellung der Prozessparameter sind Ätzraten von bis zu 10 µm/sec realisierbar. Die HF-Konzentration bewegt sich typischerweise zwischen 5 und 40 %m, wobei die Wirkung noch durch Zugabe eines Netzmittels mit einem Anteil zwischen 5 und 30 %vol verbessert werden kann. Die Stromdichten betragen je nach HF-Konzentration einige 10 mA/cm2 bis einige A/cm2. Die bei der Reaktion auftretenden Reaktionsgase können durch die Öffnungen 4, 5 entweichen, ohne die perforierte erste Schicht 2 zu zerstören. **Fig. 4** zeigt den Schichtaufbau nach diesem ersten Ätzschritt, in dem ein zusammenhängender Hohlraum 6 unterhalb der Öffnungen 4 und 5 ausgebildet wurde.

In einem nächsten Verfahrensschritt wird eine Opferschicht 7 auf die perforierte erste Schicht 2 aufgebracht, wobei die Öffnungen 4 und 5 in der ersten Schicht 2 verschlossen werden. Dazu wird im hier beschriebenen Ausführungsbeispiel SiGe in einem LPCVD Prozess weitgehend konform auf der ersten Schicht 2 abgeschieden. **Fig. 5** zeigt den Schichtaufbau nach Erreichen einer Schichtdicke der Opferschicht 7, die dem halben Öffnungsdurchmesser entspricht, so dass die Öffnungen 4 und 5 verschlossen sind. Typischerweise werden 0,5 bis 2 µm SiGe deponiert. Die kleinste Dimension der Öffnungen 5 bestimmt hierbei die zum Verschluss erforderliche Schichtdicke.

Nachfolgend wird die Opferschicht 7 planarisiert. Außerdem wird ein Rahmenbereich 8 prozessiert, was in **Fig. 6** dargestellt ist. Als Isolationsmaterial dient hier Si02.

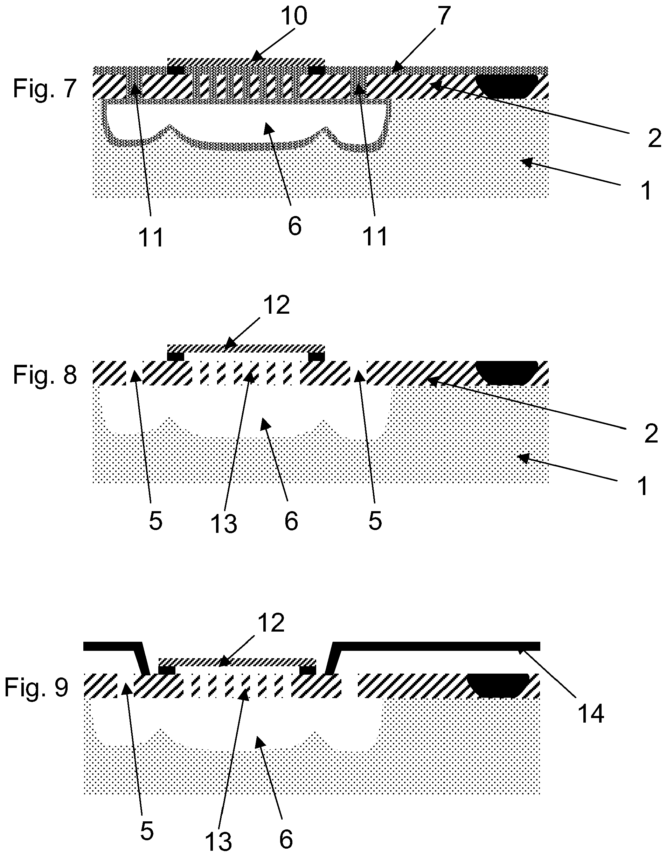

**Fig. 7** zeigt den Schichtaufbau, nachdem über der Opferschicht 7 eine dotierte Polysiliziumschicht 10 abgeschieden und strukturiert worden ist, um eine Membran aus dotiertem Polysilizium zu erzeugen. Die Membran soll hier als Aufnehmer für den Schalldruck dienen und fungiert als Elektrode zur kapazitiven Auswertung der Membrandeformationen. Das Opferschichtmaterial in den Druckausgleichsöffnungen 5 ist hier mit 11 bezeichnet.

Im nächsten Verfahrensschritt wird die Membran 12 freigelegt, indem das gesamte Opferschichtmaterial SiGe mittels C1F3-Ätzen entfernt wird. Dabei wird weder das Polysilizium der Membran 12 noch das Siliziumsubstrat 1 noch das Si02 des Rahmenbereichs 8 angegriffen. Der Ätzangriff geht von der Oberseite des Schichtaufbaus aus. Zunächst wird das frei zugängliche Material der Opferschicht 7 auf der ersten Schicht 2 entfernt. Dann wird das Opferschichtmaterial 11 in den Druckausgleichsöffnungen 5 entfernt, so dass das Ätzmedium in den Hohlraum 6 unter der ersten Schicht 2 eindringen kann und auch das Opferschichtmaterial auf der Wandung des Hohlraums 6 angreifen kann. Von hier aus wird schließlich auch das Opferschichtmaterial in den Öffnungen 4 und unter der Membran 12 entfernt. Die Membran 12 wird also mittels Ätzen des Opferschichtmaterials durch die außen liegenden Druckausgleichsöffnungen 5 und den Hohlraum 6 freigelegt. Das Ergebnis dieses zweiten Ätzschritts, nämlich eine freitragende, geschlossene Membran 12 über einer perforierten Gegenelektrode 13, ist in **Fig. 8** dargestellt. Unterhalb dieser Kondensatorstruktur befindet sich ein großes Ausgleichsvolumen in Form des Hohlraums 6.

Die freigelegten Druckausgleichsöffnungen 5 werden abschließend noch mittels Kappenwafern 14 derart zur Seite oder nach hinten abgeführt, dass auf die Membran 12 einfallender Schalldruck nicht auch über die Druckausgleichsöffnungen 5 in das Ausgleichsvolumen 6 gelangen kann. **Fig. 9** zeigt den Schichtaufbau mit zwei aufgebondeten Kappenwafern 14.

Im Rahmen des erfindungsgemäßen Verfahrens zur Herstellung eines Bauelements, wie es in Fig. 8 dargestellt ist, können an Stelle von SiGe auch andere Opferschichtmaterialien eingesetzt werden. Dafür eignet sich beispielsweise auch ein PECVD-Oxid, was in **Fig. 10** dargestellt ist. Während bei der Abscheidung von SiGe auf der ersten Schicht 2 auch die Wandung des Hohlraums 6 über die Öffnungen 4 und 5 beschichtet wird, bis diese verschlossen sind, werden die Öffnungen 4 und 5 hier durch das PECVD-Oxid der Opferschicht 15 verschlossen, ohne dass sich eine Oxidschicht auf der Wandung des Hohlraums 6 ausbildet. Dadurch lassen sich größere Abstände zwischen der Membran und der perforierten Gegenelektrode realisieren. Der Rahmenbereich 16, der die elektrische Isolation zwischen Membran und Gegenelektrode bildet, kann hier mittels SiN oder auch mittels p-Dotierung realisiert werden. Nach Abscheidung und Strukturierung einer Polysiliziumschicht als Membran wird die SiO2-Opferschicht 15 mittels HF-Dampfätzen selektiv herausgeätzt.

Des Weiteren kann die Opferschicht auch aus dotiertem Polysilizium bestehen, was in **Fig. 11** dargestellt ist. In diesem Fall wird die Siliziumstruktur vor Aufbringen der Opferschicht 17 durch thermische Oxidation 21 passiviert. Dazu reichen wenige 10 nm Oxid aus, so dass der resultierende Stress vernachlässigbar ist. Die Öffnungen 4 und 5 werden auch hier mit dem Opferschichtmaterial verschlossen. Als Membranmaterial wird ein Dielektrikum 18 verwendet. Dafür eignet sich beispielsweise Si02, SiN, Si3N4 oder SiC. Der elektrische Anschluss wird mittels Sputtern einer dünnen Metallschicht 19 realisiert.

Die Leitfähigkeit der perforierten n-dotierten Gegenelektrode 13 kann gezielt erhöht werden, indem die Dotierung der Gegenelektrode 13 durch zusätzliche oberflächennahe Implantation eingestellt wird. Dies ist in Form der Schattierung 22 in **Fig. 12** dargestellt. Die Dotierung der n-Epitaxieschicht 2 liegt typischerweise unter 10¹⁵/cm³. D.h., der spezifische Widerstand ist größer als 10 Ohmcm. In Fig. 12 ist außerdem eine n-dotierte Zone 23 im Substrat 1 im Randbereich des Hohlraums 6 unterhalb der Schicht 2 dargestellt. Diese Zone 23 wurde vor Abscheidung der Schicht 2 erzeugt. Sie wirkt als Tiefenmaske und erhöht lokal die Stabilität der Bauelementstruktur.

Falls das Erfordernis einer Anti-Stiction Schicht unter der Membran gegeben ist, kann dies beispielsweise vor Abscheiden der Membran geschehen oder nach Ätzen der Opferschicht durch die Druckausgleichsöffnungen mittels konformen Niederdruckprozessen.

Die Leistungsfähigkeit und Stabilität des erfindungsgemäßen Bauelements hängen wesentlich von der Größe und Form des Hohlraums 6 unterhalb des Gegenelements 13 ab. Durch geschickte Anordnung der Durchgangsöffnungen 4 im Gegenelement 13 kann erreicht werden, dass nicht ein einziger großer Hohlraum 6 entsteht sondern mehrere kleinere zusammenhängende Hohlräume, die durch Stützverbindungen bzw. Einschnürungen 24 teilweise getrennt sind. **Fig. 13** zeigt eine Aufsicht auf ein Bauelement mit einem so geformten Hohlraum. Durch die Stützverbindungen 24 wird die mechanische Stabilität des über dem Hohlraum 6 liegenden Gegenelements 13 verbessert, so dass bei der Herstellung des Bauelements eine größere Prozessfreiheit besteht.

Abschließend sei noch darauf hingewiesen, dass das erfindungsgemäße Bauteil nicht auf eine Anwendung als Mikrofon beschränkt ist, sondern auch einfach für andere Anwendungen, wie beispielsweise Druckmessung oder als Schallwandler, konfiguriert werden kann.

## Patentansprüche

1. Mikromechanisches Bauelement mit einem Schichtaufbau, der mindestens eine Membran (12) auf der Oberseite und mindestens ein Gegenelement (13) in einer ersten Schicht (2) umfasst,
wobei zwischen der Membran (12) und dem Gegenelement (13) ein Hohlraum ausgebildet ist und das Gegenelement (13) mindestens eine Durchgangsöffnung (4) vom Hohlraum hin zu einem Rückvolumen aufweist,
welches durch einen abgeschlossenen weiteren Hohlraum (6) unterhalb des Gegenelements (13) gebildet wird,
**dadurch gekennzeichnet, dass** dieser weitere Hohlraum (6) über mindestens eine Druckausgleichsöffnung (5) in der ersten Schicht (2) in einem Bereich neben der Membran (12) an die Oberseite des Schichtaufbaus angebunden ist.

2. Bauelement nach Anspruch 1, **dadurch gekennzeichnet, dass** der weitere Hohlraum (6) unterhalb des Gegenelements (13) mindestens eine Einschnürung (24) aufweist oder durch mehrere miteinander kommunizierende Kavernen gebildet wird.

3. Bauelement nach einem der Ansprüche 1 oder 2, **dadurch gekennzeichnet, dass** die mindestens eine Druckausgleichsöffnung (5) gegen unerwünschte Druckeinwirkung auf der Oberseite des Schichtaufbaus verkappt ist.

4. Bauelement nach einem der Ansprüche 1 bis 3, **dadurch gekennzeichnet, dass** die Membran (12) und das Gegenelement (13) als Elektroden zur kapazitiven Erfassung von Membrandeformationen fungieren.

5. Bauelement nach einem der Ansprüche 1 bis 4, **dadurch gekennzeichnet,**
**dass** der Schichtaufbau ein Substrat (1) und mindestens eine erste Schicht (2) über dem Substrat (1) umfasst, dass das Gegenelement (13) in der ersten Schicht (2) ausgebildet ist,
- **dass** die Membran (12) in mindestens einer weiteren Schicht (10) über der Gegenelektrode (13) ausgebildet ist und dass der weitere Hohlraum (6) unterhalb des Gegenelements (13) im Substrat (1) ausgebildet ist.

6. Verfahren zur Herstellung eines Bauelements mit einem Schichtaufbau, der mindestens eine Membran (12) auf der Oberseite und mindestens ein Gegenelement (13) umfasst, wobei zwischen der Membran (12) und dem Gegenelement (13) ein Hohlraum ausgebildet ist und das Gegenelement (13) mindestens eine Durchgangsöffnung (4) zu einem Rückvolumen aufweist, insbesondere zur Herstellung eines Bauelements nach einem der Ansprüche 1 bis 5,
- bei dem auf einem Substrat (1) mindestens eine erste Schicht (2) erzeugt wird,
- bei dem Öffnungen (4, 5) in der ersten Schicht (2) erzeugt werden, die sich zumindest bis zum Substrat (1) erstrecken, wobei mindestens eine Öffnung (4) als Durchgangsöffnung im Gegenelement (13) im Bereich der zu erzeugenden Membran (12) angeordnet wird und mindestens eine Öffnung (5) als Druckausgleichsöffnung in einem Bereich neben der zu erzeugenden Membran (12) angeordnet wird,
- bei dem in einem ersten Ätzschritt, der von der Oberseite des Schichtaufbaus ausgehend, über die Öffnungen (4, 5) in der ersten Schicht (2) erfolgt, ein Hohlraum (6) im Substrat (1) unter der ersten Schicht (2) erzeugt wird,
- bei dem mindestens eine Opferschicht (7) über der strukturierten ersten Schicht (2) erzeugt wird, wobei die Öffnungen (4,5) in der ersten Schicht (2) verschlossen werden,
- bei dem in der Opferschicht (7) ein Rahmenbereich (8) für die Membran (12) erzeugt wird,
- bei dem auf der Opferschicht (7) und dem Rahmenbereich (8) mindestens eine Schicht (10) aus Membranmaterial abgeschieden und strukturiert wird,
- bei dem die Membran (12) freigelegt wird, indem das Opferschichtmaterial in einem zweiten Ätzschritt entfernt wird, der von der Oberseite des Schichtaufbaus ausgehend, über die Druckausgleichsöffnung (5) in der ersten Schicht (2), den Hohlraum (6) unter der ersten Schicht (2) und die Durchgangsöffnung (4) im Gegenelement (13) erfolgt.

7. Verfahren nach Anspruch 6, bei dem ein p-dotiertes Siliziumsubstrat als Substrat (1) verwendet wird, bei dem die erste Schicht (2) durch eine n-dotierte Siliziumschicht gebildet wird, bei dem die Öffnungen (4, 5) in der ersten Schicht (2) in einem Trenchprozess erzeugt werden und bei dem der erste Ätzschritt einen Elektropoliturschritt in Flusssäure (HF) umfasst.

8. Verfahren nach Anspruch 7, bei dem die Substratoberfläche bereichsweise mit einer n-Dotierung versehen wird.

9. Verfahren nach einem der Ansprüche 7 oder 8, bei dem in der ersten Schicht (2) im Bereich des zu erzeugenden Gegenelements (13) durch oberflächennahe Implantation eine zusätzliche Dotierung erzeugt wird.

10. Verfahren nach einem der Ansprüche 7 bis 9, bei dem als Opferschicht (7) eine SiGe-Schicht durch LPCVD erzeugt wird und bei dem der zweite Ätzschritt zum Entfernen des Opferschichtmaterials ClF3-Ätzen umfasst.

11. Verfahren nach einem der Ansprüche 7 bis 9, bei dem als Opferschicht eine SiO2-Schicht (15) durch PECVD erzeugt wird und bei dem der zweite Ätzschritt zum Entfernen des Opferschichtmaterials HF-Dampfätzen umfasst.

12. Verfahren nach einem der Ansprüche 7 bis 11, bei dem die Membran (12) in einer dotierten Polysiliziumschicht (10) ausgebildet wird.

13. Verfahren nach einem der Ansprüche 7 bis 9, bei dem die nach dem ersten Ätzschritt vorliegende Siliziumstruktur insbesondere durch thermische Oxidation passiviert wird, bei dem eine Polysiliziumschicht (17) als Opferschicht erzeugt wird, und bei dem ein Dielektrikum als Membranmaterial verwendet wird, insbesondere SiO2, SiN, Si3N4 und/oder SiC.

14. Verfahren nach einem der Ansprüche 6 bis 13, bei dem in der Opferschicht (7; 15) ein isolierender Rahmenbereich (8; 16) für die Membran (12) erzeugt wird, insbesondere in Form eines SiO2- oder SiN-Bereichs oder durch eine p-Dotierung.

15. Verfahren nach einem der Ansprüche 6 bis 14, bei dem mindestens ein Kappenwafer (14) im Bereich über der Druckausgleichsöffnung (5) auf den Schichtaufbau gebondet wird.

## Claims

1. Micromechanical component having a layer construction comprising at least one membrane (12) on the top side and at least one counter-element (13) in a first layer (2),
wherein a hollow space is formed between the membrane (12) and the counter-element (13), and the counter-element (13) has at least one through opening (4) from the hollow space towards a back volume,
which is formed by a closed-off further hollow space (6) below the counter-element (13),
**characterized in that** said further hollow space (6) is linked to the top side of the layer construction via at least one pressure equalization opening (5) in the first layer (2) in a region alongside the membrane (12).

2. Component according to Claim 1, **characterized in that** the further hollow space (6) below the counter-element (13) has at least one constriction (24) or is formed by a plurality of intercommunicating cavities.

3. Component according to either of Claims 1 and 2, **characterized in that** the at least one pressure equalization opening (5) is capped against undesired action of pressure on the top side of the layer construction.

4. Component according to any of Claims 1 to 3, **characterized in that** the membrane (12) and the counter-element (13) function as electrodes for capacitively detecting membrane deformations.

5. Component according to any of Claims 1 to 4, **characterized in that** the layer construction comprises a substrate (1) and at least one first layer (2) above the substrate (1), **in that** the counter-element (13) is formed in the first layer (2),
- **in that** the membrane (12) is formed in at least one further layer (10) above the counter-electrode (13), and **in that** the further hollow space (6) is formed below the counter-element (13) in the substrate (1).

6. Method for producing a component having a layer construction comprising at least one membrane (12) on the top side and at least one counter-element (13), wherein a hollow space is formed between the membrane (12) and the counter-element (13), and the counter-element (13) has at least one through opening (4) to a back volume, in particular for producing a component according to any of Claims 1 to 5,
- wherein at least one first layer (2) is produced on a substrate (1),
- wherein openings (4, 5) are produced in the first layer (2), which openings extend at least as far as the substrate (1), wherein at least one opening (4) is arranged as through opening in the counter-element (13) in the region of the membrane (12) to be produced, and at least one opening (5) is arranged as pressure equalization opening in a region alongside the membrane (12) to be produced,
- wherein in a first etching step, which is carried out proceeding from the top side of the layer construction, via the openings (4, 5) in the first layer (2), a hollow space (6) is produced in the substrate (1) below the first layer (2),
- wherein at least one sacrificial layer (7) is produced above the structured first layer (2), wherein the openings (4, 5) in the first layer (2) are closed,
- wherein a frame region (8) for the membrane (12) is produced in the sacrificial layer (7),
- wherein at least one layer (10) composed of membrane material is deposited and structured on the sacrificial layer (7) and the frame region (8),
- wherein the membrane (12) is exposed by the sacrificial layer material being removed in a second etching step, which is carried out proceeding from the top side of the layer construction, via the pressure equalization opening (5) in the first layer (2), the hollow space (6) below the first layer (2) and the through opening (4) in the counter-element (13).

7. Method according to Claim 6, wherein a p-doped silicon substrate is used as substrate (1), wherein the first layer (2) is formed by an n-doped silicon layer, wherein the openings (4, 5) in the first layer (2) are produced in a trench process, and wherein the first etching step comprises an electropolishing step in hydrofluoric acid (HF).

8. Method according to Claim 7, wherein the substrate surface is provided regionally with an n-type doping.

9. Method according to either of Claims 7 and 8, wherein an additional doping is produced in the first layer (2) in the region of the counter-element (13) to be produced, by means of near-surface implantation.

10. Method according to any of Claims 7 to 9, wherein an SiGe layer is produced as sacrificial layer (7) by LPCVD, and wherein the second etching step for removing the sacrificial layer material comprises ClF3 etching.

11. Method according to any of Claims 7 to 9, wherein an Si02 layer (15) is produced as sacrificial layer by PECVD, and wherein the second etching step for removing the sacrificial layer material comprises HF vapour etching.

12. Method according to any of Claims 7 to 11, wherein the membrane (12) is formed in a doped polysilicon layer (10).

13. Method according to any of Claims 7 to 9, wherein the silicon structure present after the first etching step is passivated in particular by thermal oxidation, wherein a polysilicon layer (17) is produced as sacrificial layer, and wherein a dielectric is used as membrane material, in particular Si02, SiN, Si3N4 and/or SiC.

14. Method according to any of Claims 6 to 13, wherein an insulating frame region (8; 16) for the membrane (12) is produced in the sacrificial layer (7; 15), in particular in the form of an SiO2 or SiN region or by means of a p-type doping.

15. Method according to any of Claims 6 to 14, wherein at least one cap wafer (14) is bonded onto the layer construction in the region above the pressure equalization opening (5).

## Revendications

1. Composant micromécanique présentant une structure en couches, comprenant au moins une membrane (12) sur la face supérieure et au moins un contre-élément (13) dans une première couche (2),
dans lequel un espace creux est réalisé entre la membrane (12) et le contre-élément (13) et le contre-élément (13) comporte au moins une ouverture de passage (4) allant de l'espace creux vers un volume arrière,
qui est formé par un autre espace creux (6) fermé en dessous du contre-élément (13),
**caractérisé en ce que** ledit autre espace creux (6) est relié à la face supérieure de la structure en couches par l'intermédiaire d'au moins une ouverture de compensation de pression (5) ménagée dans la première couche (2) dans une zone adjacente à la membrane (12).

2. Composant selon la revendication 1, **caractérisé en ce que** l'autre espace creux (6) comporte au moins un étranglement (24) en dessous du contre-élément (13) ou **en ce qu'**il est formé par plusieurs cavités communiquant les unes avec les autres.

3. Composant selon l'une quelconque des revendications 1 ou 2, **caractérisé en ce que** l'au moins une ouverture de compensation de pression (5) est recouverte contre l'action d'une pression indésirable sur la face supérieure de la structure en couches.

4. Composant selon l'une quelconque des revendications 1 à 3, **caractérisé en ce que** la membrane (12) et le contre-élément (13) jouent le rôle d'électrodes permettant de détecter de manière capacitive des déformations de la membrane.

5. Composant selon l'une quelconque des revendications 1 à 4,
**caractérisé en ce que** la structure en couches comprend un substrat (1) et au moins une première couche (2) sur le substrat (1), **en ce que** le contre-élément (13) est réalisé dans la première couche (2),
- **en ce que** la membrane (12) est réalisée dans au moins une autre couche (10) sur la contre-électrode (13) et **en ce que** l'autre espace creux (6) est réalisé en dessous du contre-élément (13) dans le substrat (1).

6. Procédé de fabrication d'un composant présentant une structure en couches, qui comprend au moins une membrane (12) sur la face supérieure et au moins un contre-élément (13),
dans lequel un espace creux est réalisé entre la membrane (12) et le contre-élément (13) et le contre-élément (13) comporte au moins une ouverture de passage (4) débouchant dans un volume arrière, notamment pour la fabrication d'un composant selon l'une quelconque des revendications 1 à 5,
- dans lequel au moins une première couche (2) est créée sur un substrat (1),
- dans lequel des ouvertures (4, 5) sont créées dans la première couche (2), lesquelles ouverture s'étendent au moins jusqu'au substrat (1), dans lequel au moins une ouverture (4) est disposée, en tant qu'ouverture de passage, dans le contre-élément (13) dans la zone de la membrane (12) à créer, et au moins une ouverture (5) est disposée, en tant qu'ouverture de passage, dans une zone adjacente à la membrane (12) devant être créée,
- dans lequel, lors d'une première étape de gravure, qui est effectuée dans la première couche (2) en partant de la face supérieure de la structure en couches et en passant par les ouvertures (4, 5), un espace creux (6) est créé dans le substrat (1) en dessous de la première couche (2),
- dans lequel au moins une couche sacrificielle (7) est créée sur la première couche (2) structurée, dans lequel les ouvertures (4, 5) se referment dans la première couche (2),
- dans lequel une zone formant cadre (8) pour la membrane (12) est créée dans la couche sacrificielle (7),
- dans lequel au moins une couche (10) est isolée du matériau de membrane et est structurée sur la couche sacrificielle (7) et la zone formant cadre (8),
- dans lequel la membrane (12) est exposée en enlevant le matériau de couche sacrificielle lors d'une deuxième étape de gravure, qui est effectuée depuis la face supérieure de la structure en couches, par l'intermédiaire de l'ouverture de compensation de pression (5) ménagée dans la première couche (2), de l'espace de creux (6), en-dessous de la première couche (2) et de l'ouverture de passage (4) ménagée dans le contre-élément (13).

7. Procédé selon la revendication 6, dans lequel on utilise en tant que substrat (1) un substrat de silicium dopé p, dans lequel la première couche (2) est formée par une couche de silicium dopée n, dans lequel les ouvertures (4, 5) sont créées dans la première couche (2) lors d'un processus de formation de tranchées et dans lequel la première étape de gravure comprend une étape d'électropolissage dans de l'acide fluorhydrique (HF).

8. Procédé selon la revendication 7, dans lequel la surface du substrat est pourvue par endroits d'un dopage n.

9. Procédé selon l'une quelconque des revendications 7 ou 8, dans lequel un dopage supplémentaire est créé dans la première couche (2) dans la zone du contre-élément (13) devant être créé par implantation à proximité de la surface.

10. Procédé selon l'une quelconque des revendications 7 à 9, dans lequel une couche de SiGe est créée par LPCVD en tant que couche sacrificielle (7) et dans lequel la deuxième étape de gravure destinée à enlever le matériau sacrificiel comprend une gravure au CIF3.

11. Procédé selon l'une quelconque des revendications 7 à 9, dans lequel une couche de SiO2 (15) est créée par PECVD en tant que couche sacrificielle et dans lequel la deuxième étape de gravure destinée à enlever le matériau sacrificiel comprend une gravure par vapeur de HF.

12. Procédé selon l'une quelconque des revendications 7 à 11, dans lequel la membrane (12) est réalisée dans une couche de polysilicium dopée (10).

13. Procédé selon l'une quelconque des revendications 7 à 9, dans lequel la structure de silicium obtenue après la première étape de gravure est passivée, notamment par oxydation thermique, dans lequel une couche de polysilicium (17) est créée en tant que couche sacrificielle, et dans lequel un diélectrique est utilisé en tant que matériau de membrane, notamment du SiO2, du SiN, du Si3N4 et/ou du Sic.

14. Procédé selon l'une quelconque des revendications 6 à 13, dans lequel une zone formant cadre (8 ; 16) pour la membrane (12) est créée dans la couche sacrificielle (7 ; 15), notamment sous la forme d'une zone de SiO2 ou de SiN ou par dopage p.

15. Procédé selon l'une quelconque des revendications 6 à 14, dans lequel une plaquette de recouvrement (14) est soudée à la structure en couches par l'intermédiaire de l'ouverture de compensation de pression (5).
